# EUROPEAN PATENT APPLICATION

(11) **EP 1 622 195 A1**
(43) Date of publication of application: **01.02.2006**
(21) Application number: 04396050.9
(22) Date of filing: 21.07.2004
(51) Int. Cl.: H01L 21/677, G01L 27/00

(54) **Apparatus and method for testing devices fabricated in a wafer**

(71) Applicant: Afore Oy, 20810 Turku (FI)
(72) Inventor: Hannukainen, Kari, 21260 Raisio (FI)
(74) Representative: Suominen, Kaisa Liisa

(57) **Abstract**

There is being disclosed a pressure testing apparatus for devices fabricated in a wafer, the apparatus comprising a pressure chamber comprising a housing and a loading means for transporting the wafer through the housing into and out from the pressure chamber, a wafer chuck, a testing means. In the invention the loading means comprises an entrance chamber provided with an inner opening in connection with the pressure chamber and an outer opening outside the pressure chamber, and an inner lid mounted to the entrance chamber, which inner lid is arranged to cover the inner opening.

## Description

### TECHNICAL FIELD OF THE INVENTION

The invention concerns a pressure testing apparatus and a method for pressure testing according to the preambles of the independent claims presented below.

### BACKGROUND ART

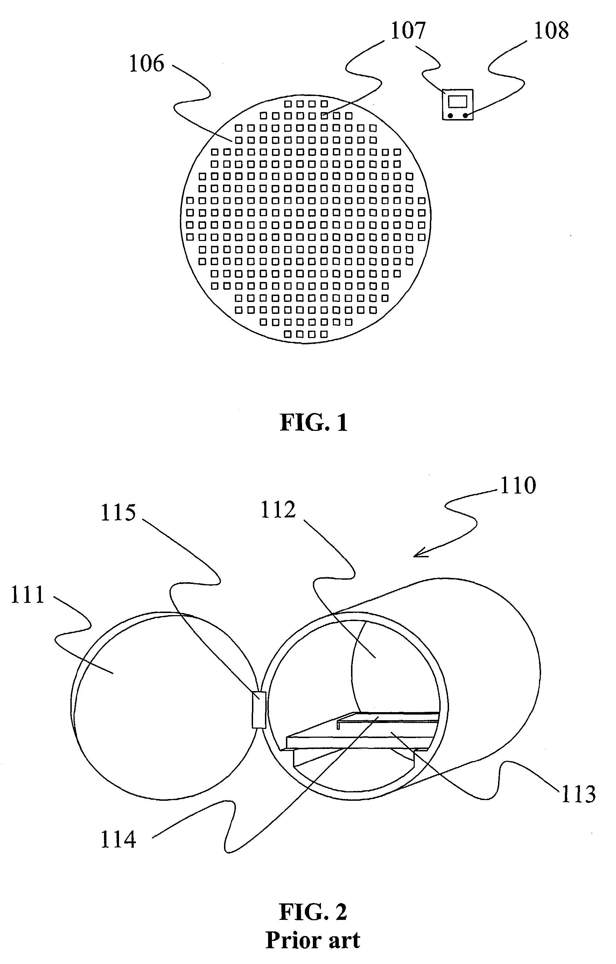

Pressure sensors are micromechanical devices, which are fabricated in a wafer, typically from 100 to 300 mm in diameter and from 200 to 500 µm in thickness. Figure 1 shows a wafer. The pressure sensors are tested while still in wafer form or after separation from each other (by dicing), using an automatic testing apparatus.

For pressure testing, the wafer or a test fixture in which the pressure sensors are placed, is loaded into the pressure chamber of the pressure testing apparatus as is shown in Figure 2. The chamber is provided with a door for loading. To test several wafers the door of the pressure chamber is opened and closed frequently. Thus, a potential disadvantage exists that dust or other particles enter the chamber during loading and contaminates the apparatus and the devices to be tested. In addition, big door requires lot of space around the apparatus and the operation of the door is difficult to automate. Thus, fully automatic operation of the tester is difficult to realize.

One known technique is presented in EP 472 112 A2. A vacuum chamber is provided with an intermediate region between the inner region of the vacuum chamber and the outer region of the vacuum chamber. When the pressure chamber is brought from low pressure or normal air pressure to state of overpressure, contaminants may occur in the intermediate region, since the pressure is the same in the chamber than in the intermediate region. Therefore, the technique is limited to low-pressure chambers. Although the technique can be used advantageously with chambers, which operate at low pressure, clear drawbacks are associated in transportation of the wafer into and out from the chamber due to the construction of such an apparatus. Since the opening mechanisms of the lids requires screws for securing the lids on the chamber, automated loading equipments can not be placed nearby the pressure chamber.

### SUMMARY OF THE INVENTION

It is therefore an object of the invention to provide a pressure testing apparatus that overcomes the above deficiencies.

Furthermore, an object of the invention is to provide a method for pressure testing devices on a wafer in a pressure chamber and a pressure testing apparatus, which can be utilized at low pressure and/or at overpressure testing of such devices.

Furthermore, an object of the invention is to provide a method for pressure testing separated devices in a test fixture in a pressure chamber, and a pressure testing apparatus, which can be utilized at low pressure and/or at overpressure testing of such devices.

These objects are achieved by the pressure testing apparatus and a method according to independent claims.

Typical pressure testing apparatus according to the invention comprises a pressure chamber, which pressure chamber comprises a housing and a loading means for transporting a wafer through the housing into and out from the pressure chamber. Typical pressure testing apparatus further comprises a wafer chuck and a testing means.

With the testing means is meant for example a probe card to control measurements in the pressure testing apparatus, probes for measuring, for example needles, and a card support for the probe card. With the devices is meant for example pressure sensors, gas sensors and circuits on a wafer or in a test fixture. In the following text the wafer may correspond to the test fixture although not specifically mentioned. With the test fixture is meant for example a plate comprising a place for each individual devices. The test fixture may be for example a metal lattice, a frame or a waffle-type carrier. Furthermore, the text fixture may be accomplished by substrate material to which the devices to be tested are attached, glued or bonded. The wafer may be for example made of glass or semiconducting material, such as silicon or gallium arsenide.

In typical pressure testing apparatus according to the invention the loading means further comprises an entrance chamber provided with an inner opening in connection with the pressure chamber and an outer opening outside the pressure chamber. Furthermore, the loading means comprises an inner lid mounted to the entrance chamber, outside the entrance chamber, which inner lid is arranged to cover the inner opening.

In typical pressure testing apparatus, the entrance chamber in the wall or in connection with the wall of the pressure chamber is purposed for transporting the wafer through the housing of the pressure chamber. The size of the entrance chamber is adapted so that the wafer can be appropriately transported through the entrance chamber. The sizes of the inner opening and the outer opening are slightly larger than the size of the wafer. Small opening enables so-called flushing, that is a small overpressure, to be applied in the entrance chamber (or into the pressure chamber) when the lids are open.

In typical pressure testing apparatus, the inner lid covers the inner opening and/or the outer lid covers the outer opening of the entrance chamber when a pressure difference is present across the said openings. Thus, the loading means makes it possible to prevent contamination of a device to be tested and the construction inside the pressure chamber. The inner lid and the outer lid do not require nuts and/or bolts for fastening the lids against the openings of the entrance chamber thus providing a relatively simple construction. Since the lid/lids is/are actuated by the actuators the pressure chamber can be opened and closed rapidly. Furthermore, the loading means can be relatively easily automated.

By an entrance chamber in connection with the pressure chamber is meant an entrance chamber arranged in the wall of the pressure chamber, as well as an entrance chamber arranged at a distance of said pressure chamber and connected to it by for example a tube-like housing. Said distance is preferably very small.

In a further embodiment of the invention the loading means further comprises an outer lid mounted to the entrance chamber, outside the entrance chamber, which outer lid is arranged to cover the outer opening of the entrance chamber.

In another further embodiment of the invention, the pressure testing apparatus comprises a positioning device arranged inside the pressure chamber. With the positioning device the chuck can be moved along the x-, y- and z-axes of the Cartesian coordinate system.

In another further embodiment of the invention, the inner lid is pivotally mounted to the entrance chamber by a first hinge. The first hinge is the inner hinge of the entrance chamber.

In another further embodiment of the invention, the outer lid is pivotally mounted to the entrance chamber by a second hinge. The second hinge is the outer hinge of the entrance chamber.

In these embodiments the inner and the outer lids are bigger in their physical size than the inner and the outer openings of the entrance chamber. Thereby, the inner lid is adapted to be sealed against a surface of the inner opening of the entrance chamber when the inner lid is in a closed position. Furthermore, the outer lid is adapted to be sealed against a surface of the outer opening of the entrance chamber when the outer lid is in a closed position.

In another further embodiment of the invention, the inner lid is actuated by a first actuator.

In another further embodiment of the invention, the first actuator is supported to the wall of the entrance chamber. The first actuator may also be supported to the inner wall of the pressure chamber.

In another further embodiment of the invention, the outer lid is actuated by a second actuator.

In another further embodiment of the invention, the second actuator is supported to the wall of the entrance chamber. The second actuator may also be supported to the outer wall of the pressure chamber.

In another further embodiment of the invention, the first and the second actuators are linear actuators. The linear actuators enable linear motion.

In another further embodiment of the invention, the first and the second actuators are controlled pneumatically. Alternatively the actuators can be controlled electrically.

In another further embodiment of the invention, the first and the second actuators are controlled by programmable logic controller (PLC). Thus, the loading means of the pressure testing apparatus may be automated using for example manually or automatically operated robot, which robot is capable of moving the wafer along x- and y-axes of Cartesian coordinate system and inserting the wafer into the chuck inside the pressure chamber. Loading of the wafer may also be done manually, for example with gripping tongs or suction equipments.

In another further embodiment of the invention, the inner lid is adapted to be opened towards the inside of the pressure chamber. The inner opening is arranged inside the pressure chamber. When the inner lid is positioned into an open position, the inner lid is moved towards the pressure chamber so that the inner opening of the entrance chamber is uncovered.

In another further embodiment of the invention, the outer lid is adapted to be opened towards the outside of the entrance chamber. The outer opening is arranged outside the pressure chamber. When the outer lid is positioned into an open position, the outer lid is moved outwards the entrance chamber so that the outer opening of the entrance chamber is uncovered.

In another further embodiment of the invention, a low pressure is applied in the entrance chamber. To seal the entrance chamber, low pressure may be applied into the entrance chamber before pressurizing the pressure chamber. Thus the inner and the outer lid are more easily tightened against the sealed openings with actuators. When the low pressure in the entrance chamber is achieved the pressurizing of the pressure chamber may be started.

In another further embodiment of the invention, an overpressure is applied in the entrance chamber when the lids are opened. Since the overpressure generates airflow due to pressure difference between the entrance chamber and the region outside the entrance chamber, the airflow prevents the contaminants, such as dust, entering the entrance chamber and thus inside the pressure chamber. During loading the wafer the pressure in the entrance chamber is reduced to a small flushing overpressure so that the actuators or loading robots are not working against a great pressure.

In another further embodiment of the invention, a pressure gauge is arranged to measure the pressure in the entrance chamber.

In another further embodiment of the invention, the inner lid is hermetically sealed against the inner opening of the entrance chamber when overpressure is applied inside the pressure chamber. The openings are provided with seals, which are arranged in grooves in the openings. At overpressure, the inner lid is pivoted into the closed position against the sealed surface of the inner opening. Alternatively, the lids are provided with seals and/or grooves for seals.

In another further embodiment of the invention, the outer lid is hermetically sealed against the outer opening when low pressure is applied inside the pressure chamber. Thus, at low pressure the inner lid is pivoted into the closed position against the sealed surface of the outer opening.

In another further embodiment of the invention, the inner or outer lid operates to seal the pressure chamber of the pressure testing apparatus when a pressure difference is present across the inner or outer opening of the entrance chamber of the pressure testing apparatus.

The invention concerns further a method for pressure testing a device on a wafer in a pressure chamber, the pressure chamber comprising a housing and a loading means for transporting the wafer through the housing into and out from the pressure chamber, the method comprising transporting a wafer to be tested into the pressure chamber through an inner opening and an outer opening of an entrance chamber arranged in connection with the pressure chamber, inserting a wafer into a wafer chuck, covering the inner opening of the pressure chamber with an inner lid, changing pressure inside the housing of the pressure chamber, testing the device on the wafer in the pressure chamber with the testing means at low pressure and/or at overpressure, transporting a wafer to be tested out from the pressure chamber through the inner opening and the outer opening of an entrance chamber.

In a further embodiment of the invention, the method further comprises covering the outer opening of the pressure chamber with an outer lid.

In another further embodiment of the invention, the method further comprises actuating the inner lid by a first actuator for closing and/or opening the inner lid.

In another further embodiment of the invention, the method further comprises actuating the outer lid by a second actuator for closing and/or opening the outer lid.

The details and embodiments described above in connection with the pressure testing apparatus also apply to the present method.

### BRIEF DESCRIPTION OF THE DRAWINGS

The invention will now be described by way of examples only with reference to accompanying drawings, in which
- Figure 1: shows a top view of a wafer that includes devices fabricated therein,
- Figure 2: shows a pressure testing apparatus according to prior art,
- Figure 3: shows a cross-sectional view of a pressure testing apparatus according to a first embodiment of the invention,
- Figure 4: shows a cross-sectional view of a loading means arranged in pressure testing apparatus according to the first embodiment of the invention,
- Figure 5: shows a cross-sectional view of a pressure testing apparatus according to a second embodiment of the invention,
- Figure 6: shows a cross-sectional view of a pressure testing apparatus according to a third embodiment of the invention.

### DETAILED DESCRIPTION OF THE DRAWINGS

Figure 1 shows a top view of a wafer that includes devices fabricated therein. The wafer 106 contains devices 107, such as pressure sensors. Furthermore, the device comprises contact pads 108.

Figure 2 shows a pressure testing apparatus according to prior art. The pressure testing apparatus 110 comprises a door 111, a pressure chamber 112, a wafer chuck 113 and a testing means 114. The door 111 is arranged pivotally in the chamber 112 by a hinge 115. To test several wafers the door 111 is opened and closed frequently. Thus the contaminants may enter the pressure chamber as the door is in its open position as shown in Figure 2.

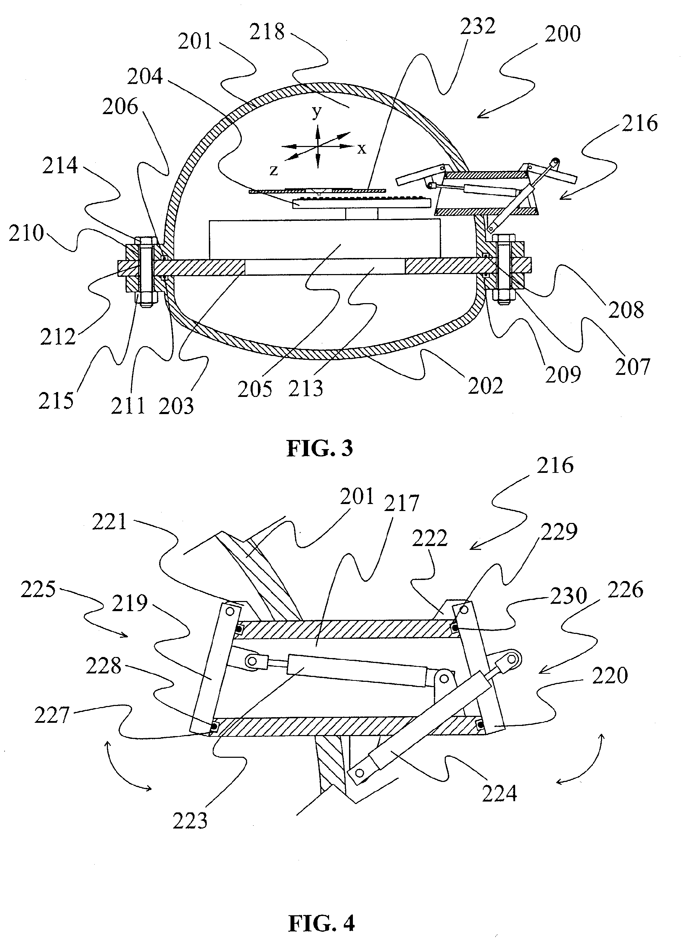

Figure 3 is a cross-sectional view of a pressure testing apparatus according to a first embodiment of the invention. The pressure testing apparatus 200 comprises a housing of a pressure chamber 218 provided with an upper part 201 and a lower part 202, a support plate 203. The pressure testing apparatus further comprises a chuck 204, a positioning device 205 and a testing means 232 such as a probe card, probes and a card support. With the positioning device the chuck 204 can be moved along the x-, y- and z-axes of the Cartesian coordinate system as is shown by arrows in Figure 3. The upper part of the housing of the pressure chamber comprises a loading means 216, shown detailed in Figure 4. In this first embodiment, the loading means 216 is positioned in such a manner that the inner opening is inside the pressure chamber 218. Further, the pressure testing apparatus comprises sealed lead-throughs (not shown) for the electrical cables from the testing means and the positioning device. The pressure testing apparatus is also provided with sealed lead-throughs, flanges and ducts for an external pumping system (not shown). The upper part 201 of the housing is provided with a groove 206 and holes 210. An O-ring seal 208 is arranged in the groove 206. Further, the lower part 202 of the housing is provided with a groove 209 and holes 207. The groove 209 is equipped with an O-ring seal 211.

The pressure testing apparatus comprises a support plate 203, which is arranged between the upper part 201 and the lower part 202. The support plate extends from inside of the housing of the pressure chamber 218 to a distance outside of housing of the pressure chamber. The distance depends on the size of the support plate. Typically the width/length of the support plate is around 1000 millimetres. The support plate is provided with an opening 213 between the upper part and the lower part inside the housing of the pressure chamber. Furthermore, same pressure is applied in the upper and the lower parts of the housing. The support plate contains holes 212, which are circumferentially positioned around the opening in the periphery of the upper part and the lower part. The radius of the opening is chosen so that the positioning device 205 can be supported from the edges of the opening by the support plate inside the pressure chamber.

Referring further to Figure 3, the upper part 201 and the lower part 202 are fastened on the support plate 203 by fastening means, for example bolts 214 and nuts 215, via the holes 207, 210, 212. The upper part and the lower part are adapted so that the sides with grooves 206, 209 are positioned against the support plate. Grooves 206 and 209 and seals 208 and 211 are arranged opposite each other on both sides of the support plate. Thus, the support plate, the upper part and the lower part of the housing of the pressure chamber forms a hermetically sealed chamber.

The diameters of holes 207, 210, 212 are slightly larger than the diameter of bolts 214. Thus, the bolts fasten the upper part firmly to the lower part but allow limited movement of the housing in relation to the support plate. This way the movement of the housing stresses less the support plate and thus makes it possible to use thinner support plates. For example, the thickness of the support plate is around 20 millimetres. Its material is for example stainless steel.

In the example of the Figure 3, areas delimited by the seals 208 and 211 against the upper and lower surfaces of the support plate are equal. The seals are circular in shape and their diameters are equal. Thus, the seals 208, 211 are equal in size.

Furthermore, the inner diameter of the open surface of the upper part of the housing towards the support plate is equal to the inner diameter of the open surface of the lower part towards the support plate. For example the said inner diameter is around 600 mm and the said diameter of the periphery of seals is around 650 mm. Thus the diameter of the opening may be around 400 millimetres.

Referring to Figure 4, a cross-sectional view of a loading means according to the first embodiment of the invention is shown. The purpose of the loading means is to transport the wafer through the housing into and out from the pressure chamber. The loading means is arranged in the housing of the pressure chamber. The loading means 216 comprises an entrance chamber 217 arranged through the wall of the upper part 201. Further, the loading means comprises an inner lid 219, an outer lid 220, an inner hinge 221 and an outer hinge 222. The entrance chamber further comprises an inner opening 225 at one end of the entrance chamber inside the pressure chamber and outer opening 226 at another end of the entrance chamber outside the pressure chamber. The inner opening contains a groove 227, which is provided with a seal 228. Furthermore, the outer opening contains a groove 229, which is provided with a seal 230.

In Figure 4, the inner lid is pivotally mounted to entrance chamber by the inner hinge for covering the inner opening. Furthermore, the inner lid is arranged outside the entrance chamber. The inner hinge is arranged in the entrance chamber inside the pressure chamber. Further, the inner lid is adapted to be opened into the pressure chamber 218. When the inner lid is closed it is sealed against the inner opening 225. The lid can be closed tightly against the opening with aid of an actuator, for example a linear actuator. The inner lid is actuated by the first actuator. The actuators can be controlled pneumatically (not shown). The first actuator 223 is arranged inside the entrance chamber. The inner lid is supported with the first actuator 223 to the walls of the entrance chamber.

The outer lid is pivotally mounted to entrance chamber by the outer hinge for covering the outer opening. Furthermore, the outer lid is arranged outside the entrance chamber. The outer hinge is arranged in the entrance chamber outside the housing of the pressure chamber. Further, the outer lid is adapted to be opened into region outside the housing of the pressure chamber and the entrance chamber. When the outer lid is closed it is sealed against the outer opening 226. The outer lid can be closed tightly against the outer opening with aid of a second actuator 224. The outer lid is actuated by the second actuator. The second actuator is arranged outside the entrance chamber and the housing of the pressure chamber. The outer lid is supported with the second actuator to the walls of the entrance chamber.

Both lids 219, 220 are bigger in their physical size than the inner and the outer openings 225, 226 and adapted so that the lids are sealed against the openings of the entrance chamber when the lids are pivoted in closed positions. In an open position the inner lid is pivoted into the pressure chamber. Furthermore, in an open position the outer lid is pivoted outwards from the entrance chamber, as is shown by arrows in Figure 4.

For loading a wafer to be tested, the chuck is positioned with the positioning device near the entrance chamber. The pressure chamber 218 is then vented, which takes a time depending on the volume of the pressure chamber. Once the pressure chamber is vented the lids 219, 220 are opened with the first and the second actuators 223, 224 respectively. The wafer is transported into pressure chamber through the inner and the outer openings of the entrance chamber and inserted into the chuck 204 inside the housing of the pressure chamber. Then the lids are closed with actuators and sealed against the openings 225, 226.

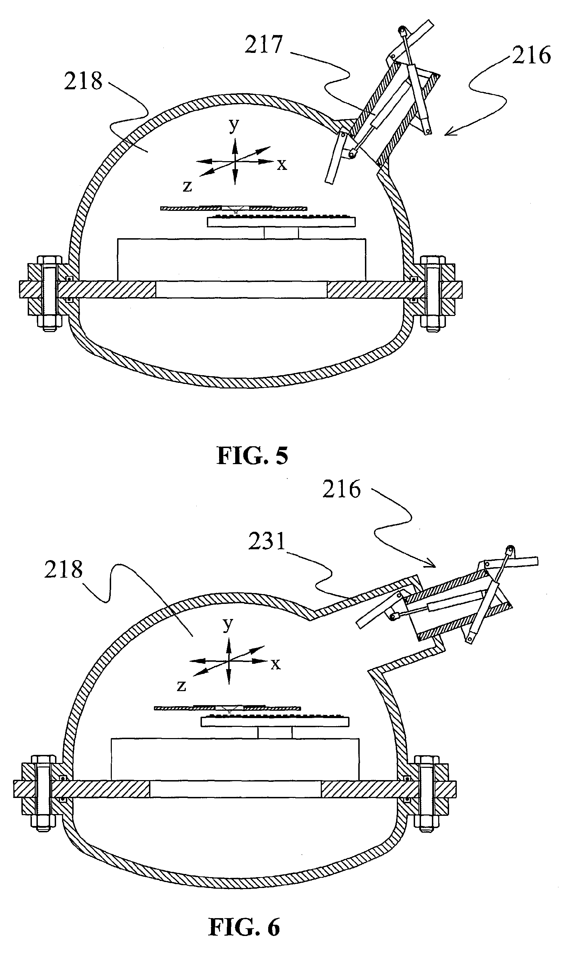

Figure 5 shows a cross-sectional view of a pressure testing apparatus according to a second embodiment of the invention. The loading means 216 is arranged obliquely in the wall of the pressure chamber 218. The entrance chamber 217 of the loading means 216 is arranged in connection with the pressure chamber 218.

Figure 6 shows a cross-sectional view of a pressure testing apparatus according to a third embodiment of the invention. The loading means 216 is arranged at a distance of the pressure chamber 218 and connected to it by a tube-like housing 231.

The pressure testing devices such as pressure sensors on the wafer or in a test fixture is carried out at low pressure or at overpressure. The pressure is drawn in the pressure chamber by an external pressure system, for example with mechanical pumping and cryogenic pumping. To test devices, the wafer is moved by the positioning device. When the probes of the testing means are placed into contact with the contact pads of the device the test can be carried out as desired. When the test is completed, the positioning device is moved again near the entrance chamber and the pressure is returned to normal air pressure by venting. The lids are then opened by the first and second actuators. The wafer is pulled out from the pressure chamber through the inner opening and the outer opening of the entrance chamber.

In pressure testing, if there is a low pressure inside the pressure chamber the outer lid is hermetically sealed tightly against the outer opening of the entrance chamber. When there is an overpressure inside the pressure chamber the inner lid is hermetically sealed tightly against the inner opening of the entrance chamber.

While the invention has been shown and described with reference to certain embodiments thereof, these are merely provided to illustrate the invention and should not construed as limitations of the invention's scope. Thus, it will be understood by those skilled in the art that various modifications in the form and details can be made therein without departing from the spirit and scope of the invention.

## Claims

1. A pressure testing apparatus (200) for devices (107) fabricated in a wafer (106), the apparatus (200) comprising
- a pressure chamber (218) comprising a housing (201, 202) and a loading means (216) for transporting the wafer (106) through the housing (201, 202) into and out from the pressure chamber (218),
- a wafer chuck (204),
- a testing means (232),
**characterised in that** the loading means (216) comprises an entrance chamber (217) provided with an inner opening (225) in connection with the pressure chamber (218) and an outer opening (226) outside the pressure chamber (218), and an inner lid (219) mounted to the entrance chamber (217), outside the entrance chamber (217), which inner lid (219) is arranged to cover the inner opening (225).

2. A pressure testing apparatus according to claim 1, **characterised in that** the loading means (216) further comprises an outer lid (220) mounted to the entrance chamber (217), outside the entrance chamber (217), which outer lid (220) is arranged to cover the outer opening (226) of the entrance chamber (217).

3. A pressure testing apparatus according to claim 1, **characterised in that** the pressure testing apparatus (200) comprises a positioning device (205) arranged inside the pressure chamber (218).

4. A pressure testing apparatus according to claim 1, **characterised in that** the inner lid (219) is pivotally mounted to the entrance chamber (217) by a first hinge (221).

5. A pressure testing apparatus according to claim 2, **characterised in that** the outer lid (220) is pivotally mounted to the entrance chamber (217) by a second hinge (222).

6. A pressure testing apparatus according to claim 1, **characterised in that** the inner lid (219) is actuated by a first actuator (223).

7. A pressure testing apparatus according to claim 6, **characterised in that** the first actuator (223) is supported to the wall of the entrance chamber (217).

8. A pressure testing apparatus according to claim 2, **characterised in that** the outer lid (220) is actuated by a second actuator (224).

9. A pressure testing apparatus according to claim 8, **characterised in that** the second actuator (224) is supported to the wall of the entrance chamber (217).

10. A pressure testing apparatus according to claims 6 or 8, **characterised in that** the first and the second actuators (223, 224) are linear actuators.

11. A pressure testing apparatus according to claims 6 or 8, **characterised in that** the first and the second actuators (223, 224) are controlled pneumatically.

12. A pressure testing apparatus according to claims 6 or 8, **characterised in that** the first and the second actuators (223, 224) are controlled by programmable logic controller (PLC).

13. A pressure testing apparatus according to claims 1 and 2, **characterised in that** low pressure is applied in the entrance chamber (217).

14. A pressure testing apparatus according to claims 1 and 2, **characterised in that** overpressure is applied in the entrance chamber (217) when lids are opened.

15. A pressure testing apparatus according to claim 13 or 14, **characterised in that** a pressure gauge is arranged to measure the pressure in the entrance chamber (217).

16. A pressure testing apparatus according to claim 1, **characterised in that** the inner lid (219) is hermetically sealed against the inner opening (225) of the entrance chamber (217) when overpressure is applied inside the pressure chamber (218).

17. A pressure testing apparatus according to claim 2, **characterised in that** the outer lid (220) is hermetically sealed against the outer opening (226) when low pressure is applied inside the pressure chamber (218).

18. A method for pressure testing a device (107) on a wafer (106) in a pressure chamber (218), the pressure chamber (218) comprising a housing (201, 202) and a loading means (216) for transporting the wafer (106) through the housing (201, 202) into and out from the pressure chamber (218), the method comprising
- transporting a wafer (106) to be tested into the pressure chamber (218) through an inner opening (225) and an outer opening (226) of an entrance chamber (217) arranged in connection with the pressure chamber (218),
- inserting a wafer (106) into a wafer chuck (204),
- covering the inner opening (225) of the pressure chamber (218) with an inner lid (219),
- changing pressure inside the housing of the pressure chamber (201, 202),
- testing the device (107) on the wafer (106) in the pressure chamber (218) with the testing means (232) at low pressure and/or at overpressure
- transporting a wafer (106) to be tested out from the pressure chamber (218) through the inner opening (225) and the outer opening (226) of an entrance chamber (217).

19. A method for pressure testing according to claim 18, **characterised in that** the method further comprises
- covering the outer opening (226) of the pressure chamber (218) with an outer lid (220).

20. A method for pressure testing according to claim 18, **characterised in that** the method further comprises
- actuating the inner lid (219) by a first actuator (223) for closing and/or opening the inner lid (219).

21. A method for pressure testing according to claim 19, **characterised in that** the method further comprises
- actuating the outer lid (220) by a second actuator (224) for closing and/or opening the outer lid (220).
